# FASCICULE DE BREVET EUROPEEN

(11) **EP 4 158 811 B1**
(45) Date de publication et mention de la délivrance du brevet: **29.10.2025**
(21) Numéro de dépôt: 21733483.8
(22) Date de dépôt: 20.05.2021
(51) Int. Cl.: H04L 1/00, H04L 1/20, H04W 88/08, H03M 1/00, H03M 7/30, H03M 7/50

(54) **PROCÉDÉ ET DISPOSITIF DE QUANTIFICATION DE DONNÉES REPRÉSENTATIVES D'UN SIGNAL RADIO REÇU PAR UNE ANTENNE RADIO D'UN RÉSEAU MOBILE**
VERFAHREN UND VORRICHTUNG ZUR QUANTISIERUNG VON DATEN, DIE FÜR EIN VON EINER FUNKANTENNE EINES MOBILFUNKNETZES EMPFANGENES FUNKSIGNAL REPRÄSENTATIV SIND
METHOD AND DEVICE FOR QUANTISING DATA REPRESENTATIVE OF A RADIO SIGNAL RECEIVED BY A RADIO ANTENNA OF A MOBILE NETWORK

(30) Priorité: 26.05.2020 FR 2005539
(43) Date de publication de la demande: 05.04.2023
(73) Titulaire: Orange, 92130 Issy-les-Moulineaux (FR)
(72) Inventeur: FERRIEUX, Alexandre, 92326 Châtillon Cedex (FR); GUILLEMIN, Fabrice, 92326 Châtillon Cedex (FR); QUINTUNA RODRIGUEZ, Veronica Karina, 92326 Châtillon Cedex (FR)
(74) Mandataire: Vidon Brevets & Stratégie
(86) Numéro de dépôt international: PCT/FR2021/050901
(87) Numéro de publication internationale: WO 2021/240096

(56) Documents cités:
- MIYAMOTO KENJI ET AL: "Unified Design of LLR Quantization and Joint Reception for Mobile Fronthaul Bandwidth Reduction", 2017 IEEE 85TH VEHICULAR TECHNOLOGY CONFERENCE (VTC SPRING), IEEE, 4 June 2017 (2017-06-04), pages 1 - 5, XP033254417, DOI: 10.1109/VTCSPRING.2017.8108426
- LING XINYUE ET AL: "Optimization of Quantization Levels for Quantize-and-Forward Relaying with QAM Signaling", 2018 ASIA-PACIFIC SIGNAL AND INFORMATION PROCESSING ASSOCIATION ANNUAL SUMMIT AND CONFERENCE (APSIPA ASC), APSIPA ORGANIZATION, 12 November 2018 (2018-11-12), pages 159 - 164, XP033525891, DOI: 10.23919/APSIPA.2018.8659534
- MIYAMOTO KENJI ET AL: "Wireless performance and mobile fronthaul bandwidth of uplink joint reception with LLR combining in split-PHY processing", JOURNAL OF COMMUNICATIONS AND NETWORKS, NEW YORK, NY, USA,IEEE, US, vol. 20, no. 6, 1 December 2018 (2018-12-01), pages 536 - 545, XP011706851, ISSN: 1229-2370, [retrieved on 20190120], DOI: 10.1109/JCN.2018.000086

## Description

### 1. Domaine de l'invention

L'invention concerne le domaine des réseaux cellulaires et plus précisément l'échange d'informations entre différentes fonctions du réseau d'accès radio (RAN pour Radio Access Network en anglais).

### 2. Art Antérieur

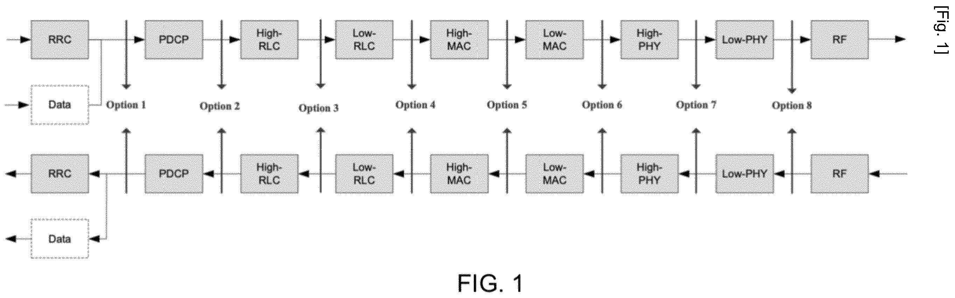

Les fonctions du réseau d'accès radio peuvent être décomposées en plusieurs blocs fonctionnels : PDCP, RLC, MAC, (de)codage, adaptation de débit (Rate Matching en anglais), Modulation, etc. De telles possibilités de décomposition fonctionnelle sont illustrées en figure 1 montrant les options de découpages possibles décrits dans 3GPP (3rd Generation Partnership Project) Study on new radio access technology : Radio access architecutre and interfaces, 3 2017, TR38.801 V14.0.7*.*

Dans les implémentations actuelles, ces différentes fonctions sont exécutées par une même plateforme de calcul qui fait partie d'une station de base (BBU pour Base Band Unit en anglais). Par exemple, une telle plateforme peut être un serveur dédié au pied d'une antenne. Or, avec l'évolution des fonctions radio et le regroupement de certaines de ces fonctions au sein de plateformes de calcul centralisées (aussi connue sous le nom de Cloud-RAN) pour notamment réaliser des économies d'échelle et une meilleure gestion des ressources radio, les fonctions du RAN peuvent être scindées selon plusieurs options (cf. la spécification TR 38.801 du 3GPP comme indiqué dans la Figure 1).

Parmi ces options, un découpage nommé split ou option 7.3 consiste à séparer les fonctions du RAN en au moins deux blocs : les fonctions basses ((dé)modulation, conversion analogique/numérique, FFT, etc.) d'un côté et les fonctions hautes d'un autre côté ((dé)codage, MAC - Media Access Control en anglais-, etc.) dans les sens montant et descendant. Les fonctions RLC (Radio Link Control en anglais) et PDCP (Packet Data Convergence Protocol en anglais) peuvent elles-mêmes être implantées encore plus haut dans le réseau (par un découpage nommé option 2 par exemple).

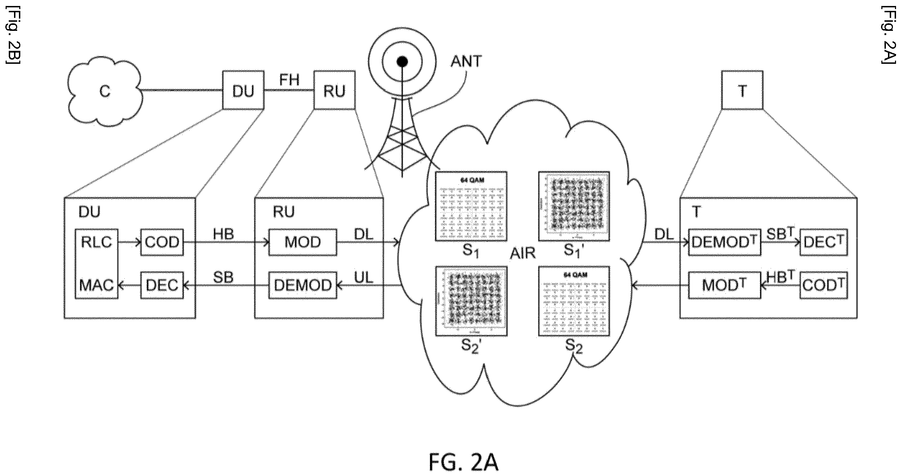

L'option 7.3 est détaillée de manière simplifiée en Figure 2A. Il est à noter que cette option 7.3 n'est considérée par le 3GPP que dans le sens descendant. La figure 2A illustre schématiquement l'échange de données entre un cœur de réseau C et une antenne ANT via laquelle un terminal T émet et reçoit des données. Comme illustrée en figure 2A, les fonctions de modulation/démodulation et de codage/décodage sont mises en oeuvre dans des équipements séparés. Par exemple, les fonctions de modulation (MOD) dans le sens descendant (DL, downlink en anglais) et de démodulation (DEMOD) dans le sens ascendant (UL, uplink en anglais) sont mises en œuvre par un premier équipement (RU) et les fonctions de codage (COD), de décodage (DEC), RLC et MAC sont mises en œuvre par un deuxième équipement (DU), les fonctions hautes PDCP, RRC peuvent être mises en œuvre par un troisième équipement (CU, non représenté). Dans le sens descendant DL, le module d'encodage (COD) transmet des données HB sous la forme de « hard bits » au module de modulation (MOD). Ces données HB hard bits sont des séquences binaires issues du codage canal mis en œuvre pour la transmission sur le réseau mobile des données source reçues du cœur de réseau. Le module de modulation (MOD) émet ensuite des symboles modulés I/Q. Dans le sens ascendant UL, le module de démodulation (DEMOD) reçoit des symboles I/Q qu'il démodule sous la forme de données SB dits « soft bits ». Le module de démodulation (DEMOD) transmet ces soft bits SB au module de décodage (DEC). Ces données SB soft bits sont des données réelles, et non binaires.

De manière générale, les opérations inverses se déroulent dans le terminal T. Il est à noter que la mise en œuvre dans le terminal est dépendante du constructeur du terminal. Toutefois, le fonctionnement général décrit par la norme est le suivant.

Le terminal T reçoit des symboles modulées I/Q en provenance de la station de base, i.e. dans le sens descendant DL. Ces symboles I/Q ont été transformés en signal radio lors de leur transmission dans l'air par la station de base. A la réception par le terminal T, ces symboles I/Q sont démodulés par le module de démodulation du terminal (DEMOD^{T}) sous la forme de soft bits (SB^{T}). Le module de démodulation (DEMOD^{T}) transmet ces « soft bits » (SB^{T}) au module de décodage du terminal (DEC^{T}).

Lors de l'émission de données par le terminal à la station de base, i.e. dans le sens ascendant UL, le module d'encodage du terminal (COD^{T}) transmet des hard bits (HB^{T}) au module de modulation du terminal (MOD^{T}) qui les module en symboles modulées I/Q qui sont ensuite émis sur le canal radio.

Des exemples de signaux I/Q sont schématiquement illustrés en figure 2A. Par exemple, la figure 2A montre :
- un signal radio-fréquence I/Q S₁ émis par la station de base ANT et le signal radio-fréquence I/Q correspondant S₁' reçu par le terminal T, et
- un signal radio-fréquence I/Q S₂ émis par le terminal T et le signal radio-fréquence I/Q correspondant S₂' reçu par la station de base ANT.

Il apparaît que les signaux reçus S₁' et S₂' sont bruités par rapport aux signaux émis correspondant S₁ et S₂.

Pour des raisons d'efficacité du décodage canal, les modules de démodulations respectivement de l'antenne et du terminal transmettent donc au module de décodage canal des données démodulées communément appelées soft bits. Les soft bits représentent les rapports de vraisemblance logarithmique (Log Likehood Ratio en anglais ou LLR) des symboles IQ reçus par l'antenne de la station de base ou du terminal après démodulation du signal reçu. Autrement dit, le signal LLR représente le ratio entre la probabilité qu'un bit particulier du signal reçu soit un 1 et la probabilité que ce bit soit un 0. L'utilisation de données LLR par le module de décodage permet d'obtenir de bonnes performances pour les méthodes de décodage canal.

Dans la plupart des implémentations, ces données LLR sont codées sur 16 ou 12 bits. Lorsque les LLR sont traités localement, i.e. que les fonctions de démodulation et de décodage sont mises en œuvre par un même équipement, cette représentation ne pose pas de problème. Toutefois, certains découpages des fonctions réseau, comme illustré en figure 2A, proposent de séparer la fonction de démodulation et la fonction de décodage. Les données LLR doivent alors être transportées entre des fonctions hautes et basses du RAN.

Des exemples de débits requis pour transmettre les données LLR sont illustrés par le tableau 1 ci-dessous pour une modulation 64 QAM. Ce débit varie en fonction du niveau de codage ou schéma de codage et modulation MCS (pour Modulation and Coding Scheme).

Il apparaît clairement que les débits peuvent atteindre des valeurs très grandes, ce qui peut poser des problèmes de dimensionnement pour le réseau fronthaul (première partie du réseau d'accès), qui relie les fonctions hautes aux fonctions basses.

### [Table 1]

**Tableau 1. Débit requis sur le fronthaul en fonction du niveau de codage des LLR pour une modulation 64QAM.**

| **Niveau de codage des LLR** | **Débit [Gbps]** |
|---|---|
| 1 | 4.05 |
| 2 | 8.10 |
| 3 | 12.15 |
| 4 | 16.20 |
| 5 | 20.25 |
| 6 | 24.30 |
| 7 | 28.35 |
| 8 | 32.40 |
| 9 | 36.45 |
| 10 | 40.50 |
| 11 | 44.55 |
| 12 | 48.60 |
| 13 | 52.65 |
| 14 | 56.70 |
| 15 | 60.75 |

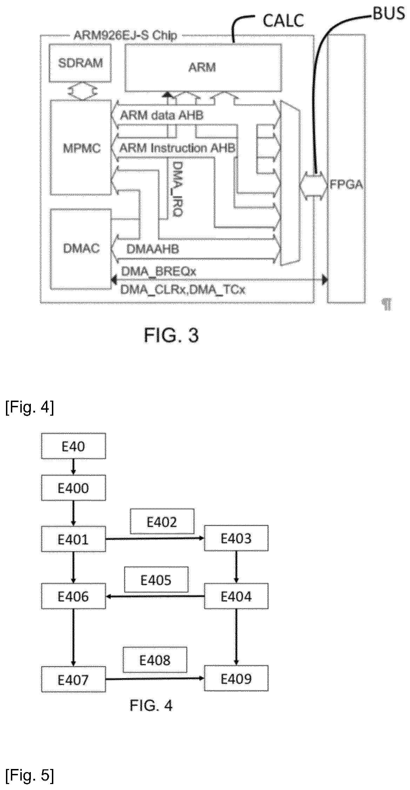

Un tel problème apparaît également quand les fonctions de codage/décodage sont déportées dans un composant FPGA (pour Field Programmable Gate Arrays en anglais) pour gagner en temps de calcul, comme par exemple illustré en figure 3. La figure 3 illustre un composant FPGA pour le codage/décodage et une plateforme de calcul CALC exécutant les autres fonctions du RAN. Selon une telle mise en œuvre, les soft bits sont transférés au composant FPGA par un bus de communication (BUS). Le débit nécessaire à la transmission des soft bits est un frein à de telles mises en œuvre, car les bus de communication ne sont pas adaptés pour transmettre de telles quantités de données avec une latence raisonnable vis-à-vis des contraintes de service.

Des techniques antérieures consistent à transférer des symboles I/Q, donc avant la démodulation, entre les fonctions hautes et basses du RAN, notamment dans l'option 7.2 retenu par ORAN. Pour réduire la bande passante entre les deux groupes de fonctions du RAN, la méthode ORAN propose de compresser les symboles I/Q transportés entre les fonctions hautes et basses du RAN. Plusieurs méthodes de compression sont identifiées dans la spécification ORAN-WG4.CUS.0-v02.00 d'ORAN (O-RAN Fronthaul Working Group, "Control, User and Synchronization Plane Specification," O-RAN, Specification, 2019)*.* Toutefois, ces méthodes peuvent conduire à une dégradation importante du signal radio, ce qui semble totalement irréaliste dans un contexte opérationnel.

Il existe donc un besoin d'améliorer l'état de la technique.

*"*Unified Design of LLR Quantization and Joint Reception for Mobile Fronthaul Bandwidth Reduction" de Miyamoto et al., Proceedings of the IEEE 85th, VTC Spring 2017 - 14.11.2017*,* divulgue la possibilité de réduire la largeur de bande MFH en utilisant une conception unifiée de la quantification LLR et de la réception conjointe, avec des seuils de quantification adaptés au SNR et à la capacité de codage des données LLR quantifiés.

*"*Optimization of Quantization Levels for Quantize-and-Forward Relaying with QAM Signaling", de Ling et al., APSIPA ASC 2018*,* divulgue un système coopératif de quantification de données reçues par des relais d'un réseau C-RAN dans lequel les LLR quantifiées sont transmises par fibre large bande à un décodeur unique et le niveau de quantification est adapté selon un schéma MCS reposant sur une optimisation conjointe de l'information mutuelle et de la quantité de trafic.

*"*Wireless performance and mobile fronthaul bandwidth of uplink joint reception with LLR combining in split-PHY processing", de Miyamoto et al., IEEE Journal of Communications and Networks, 01.12.2018*,* étudie les performances du traitement de la couche physique partagée, avec la combinaison LLR en transmission CoMP dans un C-RAN, en termes de SNR, de débit et de largeur de bande MFH par rapport aux systèmes conventionnels.

### 3. Exposé de l'invention

L'invention vient améliorer l'état de la technique. Elle concerne à cet effet un procédé d'adaptation d'une table de quantification de données représentatives d'un signal radio reçu par une antenne radio d'un réseau mobile. Un tel procédé comprend :
- l'obtention d'une information représentative d'un taux d'erreur de décodage canal d'un signal démodulé quantifié décodé issu d'une démodulation du signal radio reçu par ladite antenne, ledit signal radio démodulé ayant été quantifié par ladite table de quantification, et ledit signal radio démodulé quantifié ayant subi un décodage canal,
- l'adaptation de la table de quantification lorsque le taux d'erreur de décodage canal est supérieur à un seuil déterminé,
- la transmission d'une information représentative de l'adaptation de la table de quantification, à un dispositif de décodage canal ou à un dispositif de démodulation.

L'invention permet ainsi de réduire le débit nécessaire à la transmission des soft bits entre le dispositif de démodulation et le dispositif de décodage canal, notamment lorsque ces dispositifs sont mis en œuvre sur deux équipements distincts.

Dans le cas où le processus de décodage est mis en œuvre par un circuit spécifique, de type FPGA, la réduction de la taille de codage des softbits ou LLRs permet de réduire la bande passante sur le bus de communication entre le composant FPGA et le reste des fonctions du RAN et ainsi de gagner un facteur possible de multiplexage si plusieurs composants FPGA sont connectés au bus de communication.

Avantageusement, le procédé d'adaptation selon l'invention tient compte des performances du décodage canal et adapte la table de quantification en temps réel en fonction du BLER du signal. La table de quantification utilisée pour la quantification est ainsi optimisée en fonction du BLER observé sur le signal radio reçu. Autrement dit, la quantification du signal est optimisée de bout en bout en fonction du critère de qualité du décodage des soft bits, ce qui a pour effet d'optimiser également le débit nécessaire à la transmission des soft bits.

Ainsi, lorsque la quantification impacte trop fortement le décodage canal, ou que les conditions d'environnement de la transmission du signal radio produisent un signal trop bruité, il est possible d'adapter la table de quantification pour réduire l'impact de la quantification et limiter les erreurs de décodage.

Le procédé d'adaptation peut être mis en œuvre par le dispositif de démodulation du signal radio reçu qui reçoit dans ce cas l'information de BLER en provenance du dispositif de décodage canal du signal démodulé et transmet ensuite au dispositif de décodage canal une information indiquant l'utilisation d'une nouvelle table de quantification.

Selon une autre variante, le procédé d'adaptation peut être mis en œuvre par le dispositif de décodage canal qui détermine alors la nouvelle table de quantification et transmet ensuite au dispositif de démodulation une information indiquant une nouvelle table de quantification à utiliser.

Selon un mode particulier de réalisation de l'invention, le procédé d'adaptation comprend en outre l'adaptation de la table de quantification lorsque le taux d'erreur de décodage canal est inférieur à un autre seuil déterminé. Selon ce mode particulier de réalisation de l'invention, la table de quantification est également adaptée lorsque le BLER observé est inférieur à un seuil déterminé. Ceci permet d'augmenter la compression des données lorsque les conditions d'environnement de transmission du signal radio sont bonnes et que la quantification du signal démodulé impacte peu ou pas les performances du décodage canal.

Selon un mode alternatif de réalisation non-revendiqué, l'adaptation de la table de quantification comprend la sélection d'une nouvelle table de quantification pré-calculée. Selon ce mode particulier de réalisation de l'invention, un ensemble de tables de quantification a été pré-calculé. Ainsi, l'adaptation de la table de quantification en fonction du BLER observé est simple à mettre en oeuvre.

Selon un mode alternatif de réalisation non-revendiqué, la nouvelle table de quantification pré-calculée appartient à un groupe de tables de quantifications pré-calculées dans lequel chaque table de quantification est associée à un seuil maximal de taux d'erreur décodage canal et un seuil minimal de taux d'erreur de décodage canal, la nouvelle table de quantification étant sélectionnée en fonction de la valeur du taux d'erreur de décodage canal du signal radio reçu par rapport aux seuils minimal et maximal de taux d'erreur de décodage canal associés aux tables de quantifications du groupe.

Selon un mode particulier de réalisation de l'invention, l'adaptation de la table de quantification comprend le calcul d'une nouvelle table de quantification à partir du signal radio reçu démodulé. Selon ce mode particulier de réalisation de l'invention, un apprentissage temps réel de la table de quantification est réalisé à partir des valeurs du signal reçu. Ainsi, la table de quantification est déterminée à partir des conditions réelles de transmission.

Selon un autre mode particulier de réalisation de l'invention, chaque valeur du signal démodulé est représentative d'un rapport de vraisemblance logarithmique d'un symbole dudit signal radio reçu par ladite antenne.

Corrélativement, l'invention concerne aussi un dispositif d'adaptation d'une table de quantification de données représentatives d'un signal radio reçu par une antenne radio d'un réseau mobile, comprenant un processeur et une mémoire configurés pour :
- obtenir une information représentative d'un taux d'erreur de décodage canal d'un signal démodulé quantifié décodé issu d'une démodulation du signal radio reçu par ladite antenne, ledit signal radio démodulé ayant été quantifié par ladite table de quantification, et ledit signal radio démodulé quantifié ayant subi un décodage canal, et
- adapter la table de quantification lorsque le taux d'erreur de décodage canal est supérieur à un seuil déterminé,
- transmettre une information représentative de l'adaptation de la table de quantification, à un dispositif de décodage canal ou à un dispositif de démodulation.

L'invention concerne également un dispositif de démodulation d'un signal radio reçu par une antenne radio d'un réseau mobile, comprenant :
- un module de démodulation configuré pour démoduler ledit signal radio reçu par ladite antenne, fournissant un signal démodulé,
- un module de quantification configuré pour quantifier chaque valeur dudit signal démodulé à l'aide d'une table de quantification, fournissant un signal démodulé quantifié,
- un module de transmission configuré pour transmettre ledit signal démodulé quantifié à un module de décodage canal, et
- un dispositif d'adaptation tel que cité ci-dessus.

L'invention concerne également un dispositif de décodage canal d'un signal démodulé quantifié, comprenant :
- un module de réception configuré pour recevoir ledit signal démodulé quantifié en provenance d'un dispositif de démodulation configuré pour démoduler un signal radio reçu par une antenne radio d'un réseau mobile,
- un module de quantification inverse configuré pour quantifier inversement chaque valeur dudit signal démodulé quantifié à l'aide d'une table de dé-quantification, fournissant un signal démodulé dé-quantifié,
- un module de décodage canal configuré pour décoder ledit signal démodulé dé-quantifié.
- un module de calcul configuré pour calculer un taux d'erreur de décodage canal du démodulé dé-quantifié décodé, et
- un dispositif d'adaptation tel que cité ci-dessus.

L'invention concerne également un dispositif d'un réseau mobile comprenant :
- un dispositif de démodulation configuré pour démoduler ledit signal radio reçu par ladite antenne, fournissant un signal démodulé, et pour quantifier chaque valeur dudit signal démodulé à l'aide d'une table de quantification, fournissant un signal démodulé quantifié,
- un dispositif de décodage canal sous la forme d'un circuit programmable configuré pour mettre en œuvre un schéma de décodage canal du signal démodulé dé-quantifié,
- au moins un bus de communication apte à transmettre le signal démodulé quantifié depuis le dispositif de démodulation vers le dispositif de décodage canal, et
- un dispositif d'adaptation tel que cité ci-dessus compris dans le dispositif de démodulation ou dans le dispositif de décodage canal.

L'invention concerne aussi un serveur comprenant au moins un dispositif d'adaptation ou un dispositif de démodulation ou un dispositif de décodage canal ou encore un dispositif d'un réseau mobile, tel que décrit précédemment.

L'invention concerne également un système de réseau mobile comprenant :
- au moins une antenne radio, configurée pour recevoir un signal radio,
- au moins un équipement de mise en œuvre de fonctions basses du réseau mobile, comprenant au moins un dispositif de démodulation configuré pour démoduler ledit signal radio reçu par ladite antenne, fournissant un signal démodulé, pour quantifier chaque valeur dudit signal démodulé à l'aide d'une table de quantification, fournissant un signal démodulé quantifié, et pour transmettre ledit signal démodulé quantifié à un module de décodage canal,
- au moins un équipement de mise en œuvre de fonctions hautes du réseau mobile, comprenant au moins un dispositif de décodage canal configuré pour recevoir ledit signal démodulé quantifié en provenance du dispositif de démodulation, pour quantifier inversement chaque valeur dudit signal démodulé quantifié à l'aide d'une table de dé-quantification, fournissant un signal démodulé dé-quantifié, pour décoder ledit signal démodulé dé-quantifié, et pour calculer un taux d'erreur de décodage canal du démodulé dé-quantifié décodé,
- un dispositif d'adaptation tel que décrit précédemment compris dans le dispositif de démodulation ou dans le dispositif de décodage canal.

L'invention concerne également un programme d'ordinateur comportant des instructions pour la mise en œuvre du procédé d'adaptation cité ci-dessus selon l'un quelconque des modes particuliers de réalisation décrits précédemment, lorsque ledit programme est exécuté par un processeur. Ce procédé peut être mis en œuvre de diverses manières, notamment sous forme câblée ou sous forme logicielle.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'enregistrement ou support d'informations lisible par un ordinateur, et comportant des instructions d'un programme d'ordinateur tel que mentionné ci-dessus. Le support d'enregistrement mentionné ci-avant peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple un disque dur. D'autre part, le support d'enregistrement peut correspondre à un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'enregistrement peut correspondre à un circuit intégré dans lequel le programme est incorporé, le circuit étant adapté pour exécuter ou pour être utilisé dans l'exécution du procédé en question.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
[Fig. 1] La figure 1 illustre schématiquement différentes options de découpage des fonctions du RAN,
[Fig. 2A] La figure 2A illustre schématiquement l'émission et la réception de données selon le découpage des fonctions du RAN selon l'option 7.3,
[Fig. 2B] La figure 2B compare schématiquement le découpage des fonctions du RAN selon l'option 7.2 et l'option 7.3,
[Fig. 3] La figure 3 illustre schématiquement un composant FPGA pour le codage/décodage et une plateforme de calcul CALC exécutant les autres fonctions du RAN,
[Fig. 4] La figure 4 illustre schématiquement des étapes du procédé d'adaptation d'une table de quantification d'un signal radio démodulé selon un mode particulier de réalisation de l'invention,
[Fig. 5] La figure 5 illustre schématiquement des étapes du procédé d'adaptation d'une table de quantification d'un signal radio démodulé selon un autre mode particulier de réalisation de l'invention,
[Fig. 6] La figure 6 illustre schématiquement des étapes pour déterminer la table de quantification selon un mode particulier de réalisation de l'invention,
[Fig. 7] La figure 7 illustre des exemples de grains de quantification,
[Fig. 8] La figure 8 illustre une comparaison du BLER avant et après quantification des LLRs.
[Fig. 9] La figure 9 illustre schématiquement des étapes pour déterminer la table de quantification utilisée dans le procédé d'adaptation selon un autre mode particulier de réalisation de l'invention,
[Fig. 10] La figure 10 illustre schématiquement un dispositif de d'adaptation selon un mode particulier de réalisation de l'invention,
[Fig. 11] La figure 11 illustre schématiquement un dispositif de démodulation selon un mode particulier de réalisation de l'invention,
[Fig. 12] La figure 12 illustre schématiquement un dispositif de décodage canal selon un mode particulier de réalisation de l'invention,
[Fig. 13] La figure 13 illustre schématiquement un dispositif de réseau mobile selon un mode particulier de réalisation de l'invention.

### 5. Description d'un mode de réalisation de l'invention

La désagrégation du RAN soulève depuis son introduction des questions relatives au dimensionnement du réseau connectant les fonctions haute et basse du RAN, aussi appelé fronthaul. Le premier découpage de ces fonctions introduit dans le contexte du RAN, à savoir l'option 8, produisait des débits gigantesques, de l'ordre de 10 Gbit/s par cellule radio, sachant qu'une antenne est typiquement équipée de 3 cellules couvrant un angle de 120°.

Par la suite, d'autres découpages ont été introduits, notamment l'option 2 permettant de gérer le passage d'un terminal mobile d'une cellule à l'autre (appelé hand-over en anglais) de manière centralisée et ainsi de se passer de l'interface X2 entre antennes. Mais cette découpe ne permet pas de centraliser l'allocation de bande passante radio et le codage pour mieux exploiter les ressources radio.

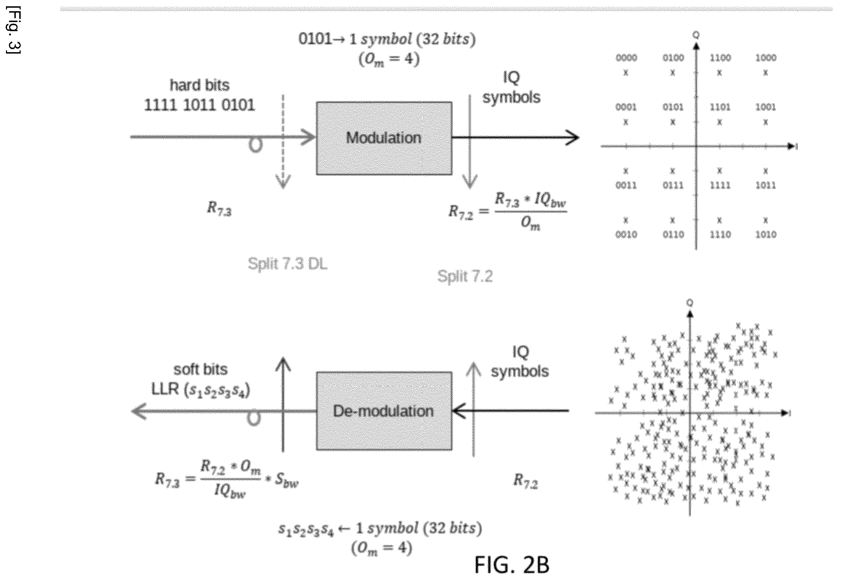

C'est pourquoi la famille des options 7.x a été introduite. L'option 7.2 est notamment considéré par l'alliance de normalisation O-RAN . Mais, comme illustré en figure 2B, l'option 7.2 consiste à transporter des symboles I/Q entre les fonctions haute et basse du RAN, ce qui peut engendrer des débits toujours très importants sur le réseau fronthaul.

Pour remédier à ce problème, l'option 7.3 a été proposée dans V. Quintuna et al. « Cloud-RAN functional split for an efficient frontaul network », article présentéà la conference, IWCMC 2020. L'option 7.3, illustrée en figure 2B également, consiste à transférer des hard bits dans le sens descendant et des soft bits (LLR) dans le sens remontant. L'option 7.3 est également illustrée en figure 2A déjà discutée. Une comparaison de débits entre les options 7.2 et 7.3 est fournie dans les tables 2, 3 et 4 ci-dessous.

### [Table 2]

**Table 2 : Débits en Gbit/s des options (splits) 7.2 et 7.3 (MIMO 8, I/Qs avec 16 bits, softbits avec 5 bits).**

| | **Modulation** | **Option 7.2** | **Option 7.3** |
|---|---|---|---|
| **Downlink (sens descendant**) | **256 QAM** | 22.2 | 4.1 |
| **Uplink** (**sens remontant**) | **64 QAM** | 21.6 | 20.25 |

### [Table 3]

**Table 3 : Comparaison des débits des options (splits) 7.2 et 7.3 (sens descendant)**

| **Modulation** | **7.2/7.3** |
|---|---|
| QPSK (2) | 16 |
| 16 QAM (4) | 8 |
| 64 QAM (6) | 5.3 |
| 256 QAM (8) | 4 |

### [Table 4]

**Table 4 : Comparaison des débits des options (splits) 7.2 et 7.3 (sens montant).**

| **Modulation** | **7.2/7.3 (codage avec 8 bits)** | **7.2/7.3 (codage avec 4 bits)** |
|---|---|---|
| QPSK (2) | 2 | 4 |
| 16 QAM (4) | 1 | 2 |
| 64 QAM (6) | 0.7 | 1.3 |
| 256 QAM (8) | 0.5 | 1 |

Il apparaît clairement que même avec l'option 7.3, les débits dans le sens montant peuvent être très élevés.

L'invention propose de réduire ces débits en proposant un codage variable des LLRs à l'aide d'une quantification de ce signal avant transmission au module de décodage canal.

La quantification est réalisée à l'aide d'une table de quantification qui peut être déterminée par exemple au préalable lors d'une phase d'apprentissage offline (pour hors ligne) selon différentes variantes de réalisation qui seront décrites plus loin. Toutefois, de telles méthodes sont statiques dans le sens où la table de quantification est déterminée à partir d'un jeu d'apprentissage dans le cadre d'un environnement donné, afin de calibrer au mieux les intervalles de quantification, i.e. la taille des godets (bins).

Selon le procédé de quantification décrit en figure 4, la quantification du signal LLR est enrichie en prenant en compte des variables d'environnement réseau lors de l'apprentissage statique. De telles variables d'environnement sont par exemple un niveau d'interférences, des conditions radioélectriques, etc.

L'espace d'apprentissage utilisé lors de l'apprentissage statique devient alors plus grand et le choix d'une table de quantification lors de la quantification effective du signal LLR est alors indexé par ces variables d'environnement. De telles variables d'environnement ne sont pas connues lors de la phase opérationnelle.

Au cours de cette phase opérationnelle, la quantification du signal LLR reçu est alors réalisée à l'aide d'un algorithme (par exemple une hystérésis en fonction de l'amélioration du BLER observé sur l'ensemble des choix possibles) qui modifie la quantification en fonction de ces variables d'environnement inconnues. Une boucle de rétroaction est ainsi mise en œuvre sur la sélection de la quantification dans le RU en fonction de l'évolution du BLER observé dans le DU.

La figure 4 illustre schématiquement des étapes du procédé de quantification et du procédé de quantification inverse selon ce mode particulier de réalisation de l'invention.

Lors d'une étape E40, un ensemble de tables de quantification est déterminé à partir d'un ensemble de signaux radio d'apprentissage. Ces tables de quantification sont déterminées de sorte à tenir compte de différentes variables d'environnement. Ces variables d'environnement sont représentatives d'un niveau de qualité de la transmission du signal radio et sont par exemple représentatives d'un niveau d'interférences, des conditions radioélectriques, etc... En fonction de ces variables d'environnement, le signal radio reçu par l'antenne est plus ou moins bruité et donc le taux d'erreur de décodage canal varie en conséquence.

Elles sont indexées par au moins un niveau de seuil de taux d'erreur de décodage (BLER). Selon la variante de réalisation décrite ici, on associe à chaque table de quantification Tᵢ un seuil minimal Sᵢ^{min} et un seuil maximal Sᵢ^{max} de taux d'erreur de décodage canal. Ces seuils de BLER permettent de déterminer si la table de quantification correspondante utilisée lors de la quantification du signal LLR est optimale.

L'étape d'apprentissage peut être réalisée lors d'une phase d'apprentissage hors ligne selon différentes variantes qui seront décrites plus loin.

A l'issue de l'étape E40, les tables de quantification déterminées et les seuils correspondantes sont stockés dans une mémoire du module de démodulation.

Lors d'une étape E400, le signal radio reçu par l'antenne de la station de base ou du terminal est démodulé. Le signal radiofréquence reçu, comprenant classiquement des symboles I/Q , est démodulé pour fournir un signal démodulé sous la forme de soft bits ou LLRs. Chaque valeur de ce signal démodulé correspond à un rapport de vraisemblance logarithmique d'un symbole du signal radio reçu par l'antenne.

Lors d'une étape E401, chaque valeur du signal démodulé est quantifiée à l'aide d'une table de quantification Tᵢ stockée dans la mémoire du module de démodulation. A l'initialisation, la table de quantification Tᵢ utilisée peut être choisie comme celle déterminée pour des variables d'environnement fournissant un signal radio très peu bruité, ou bien au contraire celle déterminée pour des variables d'environnement fournissant un signal radio très bruité, ou encore la table de quantification déterminée pour des variables d'environnement fournissant une qualité de signal radio décodé moyenne.

Lors d'une étape E402, le signal démodulé quantifié est transmis au module de décodage canal pour reconstruire le signal radio émis initialement.

Suite à la réception du signal démodulé quantifié en provenance du module de démodulation, lors d'une étape E403, chaque valeur du signal démodulé quantifié est dé-quantifiée à l'aide de la table de dé-quantification Tᵢ', fournissant un signal démodulé dé-quantifié. Ce signal démodulé dé-quantifié est ensuite décodé selon le schéma de décodage canal indiqué dans le MCS (pour Modulation and Coding Scheme en anglais).

Lors d'une étape E404, un taux d'erreur de décodage canal t_{BLER} du signal démodulé dé-quantifié décodé est calculé.

Lors d'une étape E405, une information représentative de ce taux d'erreur de décodage canal calculé t_{BLER} est transmise au module de démodulation par le module de décodage canal.

Suite à la réception de l'information représentative du taux d'erreur de décodage canal t_{BLER} du signal démodulé quantifié décodé, lors d'une étape E406, il est vérifié sur le taux d'erreur de décodage canal t_{BLER} est compris entre les seuils Sᵢ^{min} et Sᵢ^{max}. Si c'est le cas, alors il est considéré que la table de quantification Tᵢ utilisée pour quantifier le signal LLR est optimale en termes de débit/distorsion. Si ce n'est pas le cas, lors d'une étape E407, une nouvelle table de quantification est sélectionnée pour remplacer la table de quantification Tᵢ, de la façon suivante :
- si le BLER observé t_{BLER} est strictement supérieur à Sᵢ^{max}, la nouvelle table de quantification sélectionnée est la table de quantification Tⱼ qui a pour seuil Sⱼ^{min}= Sᵢ^{max}.
- si le BLER observé t_{BLER} est strictement inférieur à Sᵢ^{min}, la nouvelle table de quantification sélectionnée est la table de quantification Tₖ qui a pour seuil Sₖ^{max}= Sᵢ^{min}.

Lors d'une étape E408, une information indiquant l'utilisation de la nouvelle table sélectionnée est transmise au module de décodage canal. Lors d'une étape E409, le module de décodage canal peut ainsi mettre à jour la table de quantification inverse qu'il utilise.

Lors du traitement des signaux LLRs suivants, ceux-ci seront quantifiés à l'aide de la nouvelle table de quantification sélectionnée.

La comparaison du BLER observé avec les seuils Sᵢ^{min} et Sᵢ^{max} est réalisée ici par le module de démodulation, ainsi que la sélection d'une nouvelle table de quantification. Toutefois, ces étapes peuvent être faites par le module de décodage canal, qui informe alors dans ce cas le module de démodulation de la nouvelle table de quantification sélectionnée.

L'invention permet ainsi d'adapter de manière dynamique la table de quantification utilisée pour compresser le signal LLR en considérant les performances du décodage canal. Selon cette variante, la table de quantification utilisée oscille entre plusieurs tables de quantification jusqu'à ce que la meilleure table de quantification soit sélectionnée.

Selon la variante décrite ci-dessus, les tables de quantification sont déterminées de manière statiques et adaptées par sélection lors de la phase opérationnelle.

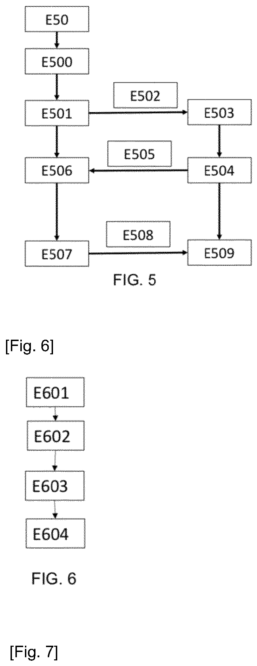

On décrit ci-après une autre variante dans laquelle la table de quantification initiale est adaptée dynamiquement par un nouveau calcul de cette table à partir du signal LLR reçu. On réalise donc un apprentissage en ligne de la table de quantification optimale. Cette variante est décrite en relation avec la figure 5.

Lors d'une étape E50, une table de quantification initiale T₀ est déterminée à partir d'un ensemble de signaux radio d'apprentissage. Par exemple, cette table de quantification est déterminée pour des variables d'environnement définissant un taux d'erreur de décodage canal moyen. Cette table T₀ est associée à un seuil maximal S₀^{max} de taux d'erreur de décodage canal. Ce seuil de BLER permet de déterminer si la table de quantification T₀ utilisée lors de la quantification du signal LLR ne dégrade pas trop les performances du décodage canal.

L'étape d'apprentissage peut être réalisée lors d'une phase d'apprentissage hors ligne selon différentes variantes qui seront décrites plus loin.

A l'issue de l'étape E50, la table de quantification déterminée et le seuil correspondant sont stockés dans une mémoire du module de démodulation.

Lors d'une étape E500, le signal radio reçu par l'antenne de la station de base ou du terminal est démodulé. Le signal radiofréquence reçu, comprenant classiquement des symboles I/Q , est démodulé pour fournir un signal démodulé sous la forme de soft bits ou LLRs. Chaque valeur de ce signal démodulé correspond à un rapport de vraisemblance logarithmique d'un symbole du signal radio reçu par l'antenne.

Lors d'une étape E501, chaque valeur du signal démodulé est quantifiée à l'aide de la table de quantification T₀ stockée dans la mémoire du module de démodulation.

Lors d'une étape E502, le signal démodulé quantifié est transmis au module de décodage canal pour reconstruire le signal radio émis initialement.

Suite à la réception du signal démodulé quantifié en provenance du module de démodulation, lors d'une étape E503, chaque valeur du signal démodulé quantifié est dé-quantifiée à l'aide de la table de dé-quantification T₀' correspondant à la table de quantification T₀, fournissant un signal démodulé dé-quantifié. Ce signal démodulé dé-quantifié est ensuite décodé selon le schéma de décodage canal indiqué dans le MCS (pour Modulation and Coding Scheme en anglais).

Lors d'une étape E504, un taux d'erreur de décodage canal t_{BLER} du signal démodulé dé-quantifié décodé est calculé.

Lors d'une étape E505, une information représentative de ce taux d'erreur de décodage canal calculé t_{BLER} est transmise au module de démodulation.

Suite à la réception de l'information représentative du taux d'erreur de décodage canal t_{BLER} du signal démodulé quantifié décodé, lors d'une étape E506, il est vérifié si le taux d'erreur de décodage canal t_{BLER} est inférieur au seuil S₀^{max}. Si c'est le cas, alors il est considéré que la table de quantification T₀ utilisée pour quantifier le signal LLR est optimale. Si ce n'est pas le cas, lors d'une étape E507, une nouvelle table de quantification est calculée pour remplacer la table de quantification T₀.

Cette nouvelle table de quantification peut être calculée par toutes méthodes adaptées, par exemple celles présentées ci-après, en utilisant les valeurs du signal LLR obtenues lors de l'étape E500.

Le seuil S₀^{max} peut également être mis à jour, par exemple en le diminuant d'une valeur déterminée.

Lors d'une étape E508, une information indiquant l'utilisation de la nouvelle table recalculée est ensuite transmise au module de décodage canal, ainsi que la table de dé-quantification correspondante. Lors d'une étape E509, le module de décodage canal peut ainsi mettre à jour la table de quantification inverse qu'il utilise.

Lors du traitement des signaux LLRs suivants, ceux-ci seront quantifiés à l'aide de la nouvelle table de quantification recalculée.

Selon un autre mode particulier de réalisation de l'invention, les deux variantes décrites ci-dessus en relation avec les figures 4 et 5 peuvent être combinées. Ainsi, la table de quantification peut être adaptée en fonction du BLER observé sur des périodes d'intégration courtes, selon la variante dans laquelle la nouvelle table de quantification est sélectionnée parmi des tables pré-calculées. Sur une période d'intégration plus longue, les tables pré-calculées sont re-calculées dynamiquement en fonction des variations long terme du système, par apprentissage à partir des signaux radio reçu lors de la phase opérationnelle.

On décrit ci-après des méthodes de détermination des tables de quantification selon différentes variantes qui peuvent être utilisées pour l'apprentissage statique des tables de quantification lors de l'étape E40 décrite ci-dessus avec la figure 4 ou lors de l'étape E50 décrite ci-dessus avec la figure 5, ou bien lors de l'apprentissage dynamique réalisé lors de l'étape E507 décrite avec la figure 5.

La figure 6 présente des étapes pour déterminer une table de quantification utilisée dans le procédé d'adaptation décrit ci-dessus.

Selon le mode particulier de réalisation décrit ici, la table de quantification est déterminée par une méthode de compension ou companding en anglais.

On considère un ensemble de signaux radiofréquence d'apprentissage reçus par une antenne et démodulés fournissant un ensemble de signaux radio démodulés. Cet ensemble de signaux radiofréquence d'apprentissage est utilisé pour estimer la distribution de la valeur absolue des LLRs.

Lors d'une étape E601, la distribution de la valeur absolue des valeurs des signaux radio démodulés est estimée. Lors d'une étape E602, pour au moins un niveau de quantification correspondant à une représentation des valeurs quantifiées du signal démodulé quantifié sur un nombre déterminé de bits, des intervalles de quantification sont calculés à partir de la distribution estimée.

Lors de l'étape E602, une quantification scalaire optimale est déterminée. Cette quantification optimale est réalisée par la méthode de companding, qui consiste à produire des godets ou bins équiprobables à partir de la distribution non uniforme estimée lors de l'étape E601. Autrement dit, la méthode de companding détermine des intervalles de quantification qui comprennent sensiblement un même nombre de valeurs du signal radio démodulé.

Pour obtenir ces intervalles de quantification, la transformation non linéaire requise est l'inversion de la distribution cumulative de probabilités. Elle s'obtient en pratique par un tri suivi d'un regroupement régulier en bins. Le résultat est un référentiel de quantification ou liste de godets.

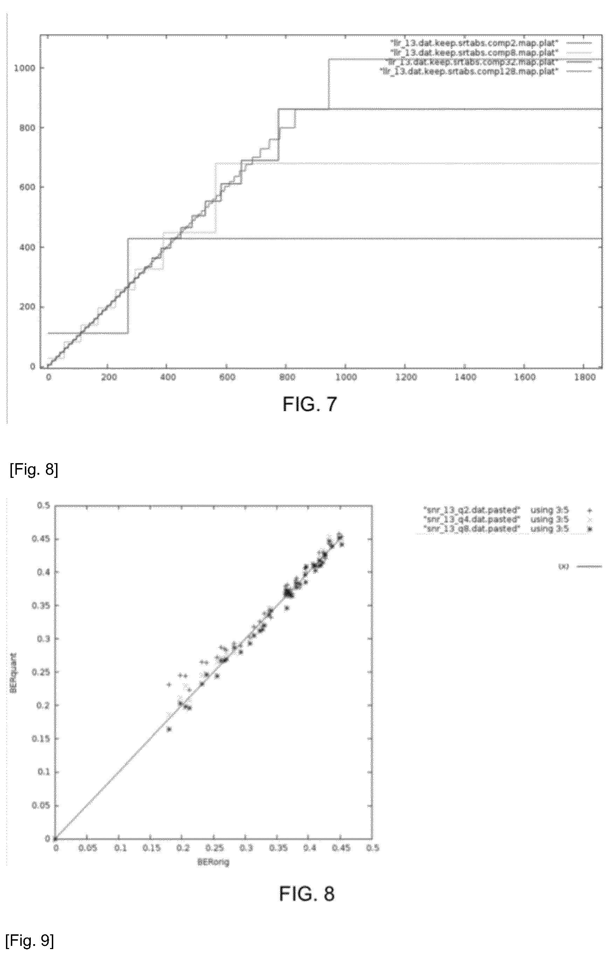

Un exemple de liste de godets ou intervalles de quantification est illustré par la Figure 7 pour différents niveaux de quantification correspondant respectivement à 2, 8, 32, et 128. On observe que le niveau de quantification correspond au nombre de godets obtenus. Par exemple, une quantification à 2 niveaux de quantification utilise deux intervalles de quantification.

L'étape E602 est mise en œuvre pour différents niveaux de quantification, par exemple les niveaux 2, 8, 32 et 128.

On obtient ainsi une table de quantification par niveau de quantification. Chaque table de quantification comprend les intervalles de quantification des valeurs du signal d'entrée et associe à chaque intervalle de quantification, l'index associé à la valeur quantifiée représentant les valeurs de cet intervalle de quantification.

Lors d'une étape E603, une table de quantification est sélectionnée parmi les tables de quantification obtenues. La table de quantification est sélectionnée de sorte qu'elle minimise un coût débit-distorsion, où le débit correspond au débit utilisé pour représenter les valeurs quantifiées et la distorsion est calculée entre les valeurs du signal radio démodulé et les valeurs quantifiées.

Selon une autre variante, la table peut être sélectionnée en considérant l'erreur de décodage canal introduite par la quantification. L'erreur de décodage peut en effet être mesurée pour vérifier que la quantification du signal LLR ne dégrade pas les performances globales du codage canal. L'erreur de décodage canal est par exemple mesurée par le BLER pour Block Error Rate en anglais, à partir du signal décodé par le module de décodage canal.

La figure 8 illustre une comparaison du BLER avant (BLERorig) et après la quantification des LLRs (BLERquant) pour différents niveaux de quantification (2, 4 et 8). Dans la Figure 8, on observe qu'une quantification reposant sur 8 bins offre un bon compromis, induisant une erreur supplémentaire minime tout en permettant un encodage des LLRs sur 4 bits (1bit de signe + 3 bits de valeur absolue). Ce qui permet de réduire la bande passante pour transporter les LLRs d'un facteur 4 par rapport au codage initial sur 16 bits.

Lors d'une étape E604, la table de quantification sélectionnée est stockée dans une mémoire du module de démodulation.

Selon le mode particulier de réalisation décrit ici, la détermination de la table de quantification a été réalisée par une méthode de « companding ». D'autres variantes de réalisation de l'invention sont possibles pour obtenir la table de quantification. Notamment, une méthode de type Lloyd-Max peut être utilisée pour définir les intervalles de quantification.

La méthode de Lloyd-Max détermine un quantifieur scalaire optimal en minimisant une distorsion. Une telle distorsion est calculée entre le signal d'entrée, i.e. les valeurs absolues des valeurs des signaux radio démodulés, et le signal reconstruit, i.e. les valeurs absolues des valeurs des signaux radio démodulés quantifiées et dé-quantifiées.

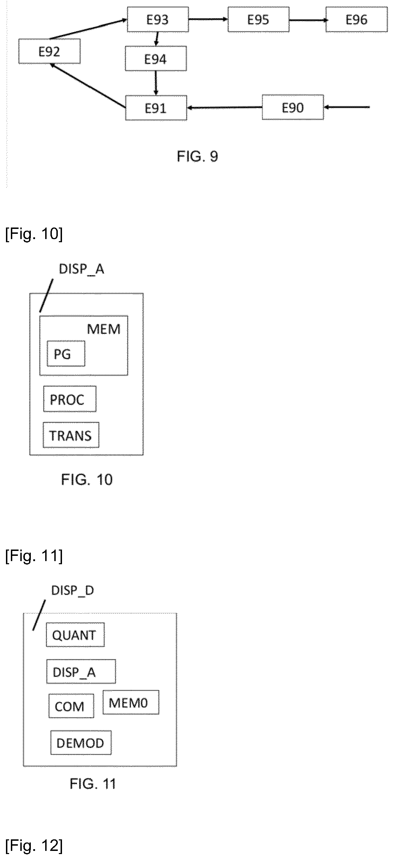

La figure 9 illustre schématiquement des étapes pour déterminer la table de quantification utilisée dans le procédé d'adaptation selon un autre mode particulier de réalisation de l'invention. Selon ce mode particulier de réalisation de l'invention, la ou les tables de quantification sont déterminées de sorte à ne pas dégrader les performances globales du codage canal, mesurées par le BLER (pour Bloc Error Rate en anglais). Notamment, selon ce mode particulier de réalisation, une détermination de la table de quantification est réalisée lors de la phase d'apprentissage selon une optimisation de bout en bout tenant compte de la performance globale du codage canal. Selon ce mode particulier de réalisation de l'invention, la chaîne complète de décodage est intégrée dans la boucle d'optimisation, afin de trouver les paramètres optimaux pour le critère de qualité du décodage des LLRs.

En raison de sa structure (Turbo-Decoder, LDPC, Polar Codes), la qualité de décodage est une fonction non dérivable des paramètres d'entrée qui sont les pas de quantification des LLRs. Ainsi, toute méthode classique d'optimisation à base de descente de gradient est exclue.

Des méthodes "sans gradient" sont utilisées, comme par exemple les algorithmes génétiques, mais d'autres méthodes d'optimisation sont envisageables (par exemple recuit simulé). Dans ces méthodes, on considère un ensemble de vecteurs de l'espace de paramètres qui sont des "candidats", et une "fonction d'adéquation" définie sur cet espace, qu'on cherche à maximiser. Un vecteur de l'espace de paramètres correspond à une table de quantification définissant les intervalles de quantifications ou pas de quantification pour quantifier les valeurs du signal LLR. Selon ce mode particulier de réalisation, la table de quantification est déterminée à partir d'un ensemble de signaux LLRs d'apprentissage.

L'ensemble de signaux LLRs d'apprentissage utilisé dans le processus d'optimisation décrit ci-dessous correspond à des signaux radio, classiquement des symboles I/Q, transmis selon un niveau de codage canal et démodulé pour fournir un signal démodulé sous la forme de soft bits ou LLRs. Chaque valeur de ce signal démodulé correspond à un rapport de vraisemblance logarithmique d'un symbole du signal radio reçu par l'antenne.

Lors d'une étape E90, un ensemble de vecteurs de quantification candidats est déterminé.

A l'initialisation, on détermine donc un ensemble de tables de quantification candidates, par exemple par une méthode de type « companding ».

Puis, pour chaque vecteur de quantification candidat, lors d'une étape E91, les signaux LLRs d'apprentissage sont quantifiés à l'aide du vecteur de quantification candidat, fournissant des signaux LLRs d'apprentissage quantifiés.

Lors d'une étape E92, les signaux LLRs d'apprentissage quantifiés sont décodés selon le niveau de codage canal. Préalablement au décodage canal, ces signaux LLRs d'apprentissage quantifiés sont dé-quantifiés.

Lors d'une étape E93, une erreur est calculée entre les signaux LLRs d'apprentissage quantifiés décodés et les signaux LLRs d'apprentissage décodés non quantifiés, selon la fonction d'adéquation choisie.

Lors d'une étape E95, on sélectionne le vecteur de quantification de l'ensemble des vecteurs de quantification candidats qui minimise l'erreur entre les signaux LLRs d'apprentissage quantifiés décodés et les signaux LLRs d'apprentissage décodés non quantifiés.

Selon une variante de ce mode particulier de réalisation de l'invention, la phase d'optimisation est basée sur un algorithme génétique. Selon ce mode particulier de réalisation de l'invention, le vecteur de quantification est sélectionné à l'étape E95, si un critère d'arrêt de l'algorithme est satisfait. Un tel critère d'arrêt peut comprendre un nombre maximal d'itérations de l'algorithme atteint, un critère de convergence de l'algorithme atteint.

Si le critère d'arrêt n'est pas atteint, lors d'une étape E94, une optimisation des vecteurs de quantification candidats est réalisée, et le procédé itère les étapes E91-E93 pour le nouvel ensemble de vecteurs de quantification candidats.

Dans le cas des algorithmes génétiques tels qu'utilisés dans l'invention, on fait "évoluer" l'ensemble de vecteurs de quantification candidats comme une "population d'individus" en appliquant des principes tirés de la théorie de l'évolution: probabilité de reproduction proportionnelle à la fonction d'adéquation, mutations aléatoires, hybridations aléatoires. Une telle méthode produit une amélioration progressive de l'adéquation du meilleur vecteur de quantification candidat. A la convergence, on a un optimum local.

La mise en œuvre de cette variante consiste à utiliser une méthode « sans gradient » e.g., l'algorithme génétique sur un jeu de données représentatif, ici les signaux LLRs d'apprentissage. La fonction d'adéquation est une évaluation de la performance d'un décodeur du type considéré (Turbo/LDPC/Polar), et déterminé par le niveau de codage canal MCS considéré. Le grand nombre d'évaluations nécessaires (nombreux individus et générations) peut nécessiter le recours à du matériel accéléré pour le décodage, pendant cette phase d'optimisation.

Mais une fois la convergence obtenue ou le critère d'arrêt satisfait, le vecteur de quantification candidat optimal est extrait (E95), et lors d'une étape E96, mémorisé par le module de démodulation.

Ce vecteur de quantification optimal est ensuite exploité dans un système temps réel : il s'agit d'une table de quantification.

La variante décrite en relation avec la figure 9 est décrite dans le cas de la minimisation du BLER. Selon une variante, le procédé d'optimisation décrit en figure 9 peut être mis en oeuvre en minimisant l'erreur entre les signaux LLRs d'apprentissage fournis en entrée et les signaux LLRs d'apprentissage quantifiés et dé-quantifiés. Selon cette variante, il n'est pas nécessaire de procéder au décodage canal des signaux LLRs d'apprentissage quantifiés. Cette variante est plus simple en termes de coût calculatoire, mais le vecteur de quantification sélectionné ne tient pas compte des performances du décodage canal.

Les méthodes de détermination d'une table de quantification décrite ci-dessus sont mises en oeuvre pour des variables d'environnement (niveau d'interférence, conditions radioélectriques) connues. La méthode de détermination choisie est appliquée pour différents jeux de variables d'environnement, fournissant respectivement différentes qualités de signal radio décodé. Une table de quantification est déterminée pour chaque jeu de variables d'environnement. Des seuils de BLER correspondant à chaque jeu de variables d'environnement sont associés à chaque table de quantification. Par exemple, on définit un seuil minimal et un seul maximal définissant un intervalle de BLER dans lequel le BLER observé du signal radio doit se situer lors de la phase opérationnelle lorsque le signal démodulé de ce signal radio est quantifié avec la table de quantification correspondant aux seuils. Dans d'autres exemples, un seul seuil par table de quantification peut être utilisé, ce seuil définissant la limite maximale du BLER observé. Si le BLER observé est supérieur à ce seuil, la table de quantification doit être adaptée.

La figure 10 illustre schématiquement un dispositif de d'adaptation DISP_A selon un mode particulier de réalisation de l'invention. Un tel dispositif est notamment configuré pour mettre en oeuvre le procédé d'adaptation selon l'un quelconque des modes particuliers de réalisation de l'invention décrits ci-dessus.

Le dispositif d'adaptation DISP_A comprend notamment un processeur PROC et une mémoire MEM configurés pour obtenir une information représentative d'un taux d'erreur de décodage canal d'un signal démodulé quantifié décodé issu d'une démodulation du signal radio reçu par ladite antenne, ledit signal radio démodulé ayant été quantifié par ladite table de quantification, et ledit signal radio démodulé quantifié ayant subi un décodage canal, et adapter la table de quantification lorsque le taux d'erreur de décodage canal est supérieur à un seuil déterminé. Ces fonctions peuvent être mises au moyen d'instructions d'un programme d'ordinateur PG stocké en mémoire MEM et exécutées par le processeur PROC.

Le dispositif d'adaptation DISP_A comprend également un module de transmission TRANS pour transmettre une information représentative de l'adaptation de la table de quantification, à un dispositif de décodage canal ou à un dispositif de démodulation.

Selon un mode particulier de réalisation de l'invention, ce dispositif d'adaptation est compris dans un dispositif de démodulation. Ce dispositif de démodulation correspond par exemple au module de démodulation de l'équipement RU de la figure 2A.

Selon un autre mode particulier de réalisation de l'invention, ce dispositif d'adaptation est compris dans un dispositif de décodage canal. Ce dispositif de décodage canal correspond par exemple au module de décodage canal de l'équipement DU de la figure 2A.

La figure 11 illustre schématiquement un dispositif de démodulation DISP_D selon un mode particulier de réalisation de l'invention. Un tel dispositif est notamment configuré pour mettre en œuvre le procédé d'adaptation selon l'un quelconque des modes particuliers de réalisation de l'invention décrits ci-dessus.

Le dispositif de démodulation DISP_D comprend notamment :
- un module de démodulation DEMOD configuré pour démoduler un signal radio reçu par un antenne, fournissant un signal démodulé,
- un module de quantification QUANT configuré pour quantifier chaque valeur dudit signal démodulé à l'aide d'une table de quantification stockée en mémoire MEM0, fournissant un signal démodulé quantifié.
- un module de transmission COM configuré pour transmettre ledit signal démodulé quantifié à un dispositif de décodage canal, et
- un dispositif d'adaptation DISP_A décrit en relation avec la figure 10.

Selon un mode particulier de réalisation de l'invention, ce dispositif de démodulation correspond par exemple au module de démodulation de l'équipement RU de la figure 2A.

Selon un mode particulier de réalisation de l'invention, le dispositif de décodage canal de l'équipement DU de la figure 2A est configuré pour mettre à jour la table de dé-quantification utilisée pour dé-quantifier le signal démodulé quantifié avant le décodage canal de ce signal en fonction d'une information transmise par le dispositif de démodulation. L'invention concerne également un tel dispositif de décodage canal adapté.

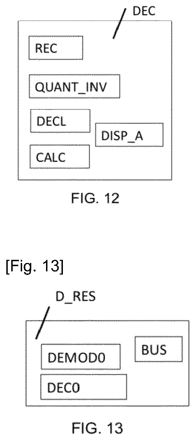

La figure 12 illustre schématiquement un dispositif de décodage canal DEC selon un mode particulier de réalisation de l'invention. Un tel dispositif est notamment configuré pour mettre en œuvre le procédé d'adaptation selon l'un quelconque des modes particuliers de réalisation de l'invention décrits ci-dessus.

Le dispositif de décodage canal DEC comprend notamment :
- un module de réception REC configuré pour recevoir ledit signal démodulé quantifié en provenance d'un dispositif de démodulation configuré pour démoduler un signal radio reçu par une antenne radio d'un réseau mobile,
- un module de quantification inverse QUANT_INV configuré pour quantifier inversement chaque valeur dudit signal démodulé quantifié à l'aide d'une table de dé-quantification, fournissant un signal démodulé dé-quantifié,
- un module de décodage canal DECL configuré pour décoder ledit signal démodulé dé-quantifié,
- un module de calcul CALC configuré pour calculer un taux d'erreur de décodage canal du démodulé dé-quantifié décodé, et
- un dispositif d'adaptation DISP_A décrit en relation avec la figure 10.

Selon un mode particulier de réalisation de l'invention, ce dispositif de décodage canal correspond par exemple au module de décodage canal de l'équipement DU de la figure 2A.

Selon un mode particulier de réalisation de l'invention, le dispositif de démodulation de l'équipement RU de la figure 2A est configuré pour mettre à jour la table de quantification utilisée pour quantifier le signal démodulé avant la transmission au dispositif de décodage canal, en fonction d'une information transmise par le dispositif de décodage canal. L'invention concerne également un tel dispositif de démodulation adapté.

La figure 13 illustre schématiquement un dispositif de réseau mobile D_RES selon un mode particulier de réalisation de l'invention.. Un tel dispositif est notamment configuré pour mettre en œuvre le procédé d'adaptation selon l'un quelconque des modes particuliers de réalisation de l'invention décrits ci-dessus.

Le dispositif de réseau mobile D_RES comprend notamment :
- un dispositif de démodulation DEMOD0 configuré pour démoduler ledit signal radio reçu par ladite antenne, fournissant un signal démodulé, et pour quantifier chaque valeur dudit signal démodulé à l'aide d'une table de quantification, fournissant un signal démodulé quantifié,
- un dispositif de décodage canal DEC0 sous la forme d'un circuit programmable configuré pour mettre en œuvre un schéma de décodage canal du signal démodulé dé-quantifié,
- au moins un bus de communication BUS apte à transmettre le signal démodulé quantifié depuis le dispositif de démodulation vers le dispositif de décodage canal.

Selon ce mode particulier de réalisation de l'invention, un dispositif d'adaptation DISP_A décrit en relation avec la figure 10 est compris dans le dispositif de démodulation ou dans le dispositif de décodage canal.

## Revendications

1. Procédé d'adaptation d'une table de quantification de données représentatives d'un signal radio reçu par une antenne radio d'un réseau mobile, comprenant :
- l'obtention d'une information représentative d'un taux d'erreur de décodage canal d'un signal démodulé quantifié décodé issu d'une démodulation du signal radio reçu par ladite antenne, ledit signal radio démodulé ayant été quantifié par ladite table de quantification, et ledit signal radio démodulé quantifié ayant subi un décodage canal,
- l'adaptation de la table de quantification lorsque le taux d'erreur de décodage canal est supérieur à un seuil déterminé,
- la transmission d'une information représentative de l'adaptation de la table de quantification, à un dispositif de décodage canal ou à un dispositif de démodulation,
l'adaptation de la table de quantification comprenant le calcul d'une nouvelle table de quantification à partir du signal radio reçu démodulé.

2. Procédé selon la revendication 1, comprenant en outre l'adaptation de la table de quantification lorsque le taux d'erreur de décodage canal est inférieur à un autre seuil déterminé.

3. Procédé selon l'une quelconque des revendications 1 à 2, dans lequel chaque valeur du signal démodulé est représentative d'un rapport de vraisemblance logarithmique d'un symbole dudit signal radio reçu par ladite antenne.

4. Dispositif d'adaptation d'une table de quantification de données représentatives d'un signal radio reçu par une antenne radio d'un réseau mobile, comprenant un processeur et une mémoire configurés pour :
- obtenir une information représentative d'un taux d'erreur de décodage canal d'un signal démodulé quantifié décodé issu d'une démodulation du signal radio reçu par ladite antenne, ledit signal radio démodulé ayant été quantifié par ladite table de quantification, et ledit signal radio démodulé quantifié ayant subi un décodage canal, et
- adapter la table de quantification lorsque le taux d'erreur de décodage canal est supérieur à un seuil déterminé,
- transmettre une information représentative de l'adaptation de la table de quantification, à un dispositif de décodage canal ou à un dispositif de démodulation,
la table de quantification étant adaptée en tenant compte d'une nouvelle table de quantification calculée à partir du signal radio démodulé.

5. Dispositif de démodulation d'un signal radio reçu par une antenne radio d'un réseau mobile, comprenant :
- un module de démodulation configuré pour démoduler ledit signal radio reçu par ladite antenne, fournissant un signal démodulé,
- un module de quantification configuré pour quantifier chaque valeur dudit signal démodulé à l'aide d'une table de quantification, fournissant un signal démodulé quantifié,
- un module de transmission configuré pour transmettre ledit signal démodulé quantifié à un module de décodage canal, et
- un dispositif d'adaptation selon la revendication 4.

6. Dispositif de décodage canal d'un signal démodulé quantifié, comprenant :
- un module de réception configuré pour recevoir ledit signal démodulé quantifié en provenance d'un dispositif de démodulation configuré pour démoduler un signal radio reçu par une antenne radio d'un réseau mobile,
- un module de quantification inverse configuré pour quantifier inversement chaque valeur dudit signal démodulé quantifié à l'aide d'une table de dé-quantification, fournissant un signal démodulé dé-quantifié,
- un module de décodage canal configuré pour décoder ledit signal démodulé dé-quantifié,
- un module de calcul configuré pour calculer un taux d'erreur de décodage canal dudit signal démodulé dé-quantifié décodé, et
- un dispositif d'adaptation selon la revendication 4.

7. Dispositif d'un réseau mobile comprenant :
- un dispositif de démodulation configuré pour démoduler ledit signal radio reçu par ladite antenne, fournissant un signal démodulé, et pour quantifier chaque valeur dudit signal démodulé à l'aide d'une table de quantification, fournissant un signal démodulé quantifié,
- un dispositif de décodage canal sous la forme d'un circuit programmable configuré pour mettre en œuvre un schéma de décodage canal du signal démodulé dé-quantifié,
- au moins un bus de communication apte à transmettre le signal démodulé quantifié depuis le dispositif de démodulation vers le dispositif de décodage canal, et
- un dispositif d'adaptation selon la revendication 4 compris dans le dispositif de démodulation ou dans le dispositif de décodage canal.

8. Serveur comprenant au moins un dispositif selon l'une quelconque des revendications 5 à 7.

9. Système de réseau mobile comprenant :
- au moins une antenne radio, configurée pour recevoir un signal radio,
- au moins un équipement de mise en œuvre de fonctions basses du réseau mobile, comprenant au moins un dispositif de démodulation configuré pour démoduler ledit signal radio reçu par ladite antenne, fournissant un signal démodulé, pour quantifier chaque valeur dudit signal démodulé à l'aide d'une table de quantification, fournissant un signal démodulé quantifié, et pour transmettre ledit signal démodulé quantifié à un module de décodage canal,
- au moins un équipement de mise en œuvre de fonctions hautes du réseau mobile, comprenant au moins un dispositif de décodage canal configuré pour recevoir ledit signal démodulé quantifié en provenance du dispositif de démodulation, pour quantifier inversement chaque valeur dudit signal démodulé quantifié à l'aide d'une table de dé-quantification, fournissant un signal démodulé dé-quantifié, pour décoder ledit signal démodulé dé-quantifié, et pour calculer un taux d'erreur de décodage canal dudit signal démodulé dé-quantifié décodé,
- un dispositif d'adaptation selon la revendication 4 compris dans le dispositif de démodulation ou dans le dispositif de décodage canal.

## Patentansprüche

1. Verfahren zur Anpassung einer Quantisierungstabelle für Daten, die für ein von einer Funkantenne eines Mobilfunknetzes empfangenes Funksignal repräsentativ sind, umfassend:
- Erhalten einer Information, die eine Kanal-Decodierungsfehlerrate eines quantisierten demodulierten Signals repräsentiert, das aus einer Demodulation des von der Antenne empfangenen Funksignals stammt, wobei das demodulierte Funksignal durch die Quantisierungstabelle quantisiert wurde und das quantisierte demodulierte Funksignal einer Kanal-Decodierung unterzogen wurde,
- Anpassung der Quantisierungstabelle, wenn die Kanal-Decodierungsfehlerrate einen bestimmten Schwellenwert überschreitet,
- Übertragung einer Information, die die Anpassung der Quantisierungstabelle repräsentiert, auf eine Kanal-Decodierungsvorrichtung oder eine Demodulationsvorrichtung, wobei das Anpassen der Quantisierungstabelle die Berechnung einer neuen Quantisierungstabelle aus dem empfangenen demodulierten Funksignal umfasst.

2. Verfahren nach Anspruch 1, das ferner die Anpassung der Quantisierungstabelle umfasst, wenn die Kanal-Decodierungsfehlerrate einen anderen bestimmten Schwellenwert unterschreitet.

3. Verfahren nach einem der Ansprüche 1 bis 2, wobei jeder Wert des demodulierten Signals ein logarithmisches Wahrscheinlichkeitsverhältnis eines Symbols des von der Antenne empfangenen Funksignals repräsentiert.

4. Vorrichtung zur Anpassung einer Quantisierungstabelle von Daten, die ein von einer Funkantenne eines Mobilfunknetzes empfangenes Funksignal repräsentieren, umfassend einen Prozessor und einen Speicher, die so konfiguriert sind, dass sie:
- eine Information erhalten, die eine Kanal-Decodierungsfehlerrate eines quantisierten demodulierten Signals repräsentiert, das aus einer Demodulation des von der Antenne empfangenen Funksignals stammt, wobei das demodulierte Funksignal durch die Quantisierungstabelle quantisiert wurde und das quantisierte demodulierte Funksignal einer Kanal-Decodierung unterzogen wurde, und
- die Quantisierungstabelle anpassen, wenn die Kanal-Decodierungsfehlerrate einen bestimmten Schwellenwert überschreitet,
- eine Information, die die Anpassung der Quantisierungstabelle repräsentiert, an eine Kanal-Decodierungsvorrichtung oder eine Demodulationsvorrichtung übertragen, wobei die Quantisierungstabelle unter Berücksichtigung einer neuen Quantisierungstabelle angepasst wird, die aus dem demodulierten Funksignal berechnet wird.

5. Vorrichtung zur Demodulation eines von einer Funkantenne eines Mobilfunknetzes empfangenen Funksignals, umfassend:
- ein Demodulationsmodul, das zum Demodulieren des von der Antenne empfangenen Funksignals konfiguriert ist und ein demoduliertes Signal bereitstellt,
- ein Quantisierungsmodul, das so konfiguriert ist, dass es jeden Wert des demodulierten Signals anhand einer Quantisierungstabelle quantisiert und ein quantisiertes demoduliertes Signal bereitstellt,
- ein Übertragungsmodul, das so konfiguriert ist, dass es das quantisierte demodulierte Signal an ein Kanal-Decodierungsmodul überträgt, und
- eine Anpassungsvorrichtung nach Anspruch 4.

6. Vorrichtung zur Decodierung eines quantisierten demodulierten Signals, umfassend:
- ein Empfangsmodul, das so konfiguriert ist, dass es das quantisierte demodulierte Signal von einer Demodulationsvorrichtung empfängt, die so konfiguriert ist, dass sie ein von einer Funkantenne eines Mobilfunknetzes empfangenes Funksignal demoduliert,
- ein inverses Quantisierungsmodul, das so konfiguriert ist, dass es jeden Wert des quantisierten demodulierten Signals mithilfe einer Dequantisierungstabelle invers quantisiert und ein dequantisiertes demoduliertes Signal bereitstellt,
- ein Kanal-Decodierungsmodul, das zum Decodieren des dequantisierten demodulierten Signals konfiguriert ist,
- ein Berechnungsmodul, das zum Berechnen einer Kanal-Decodierungsfehlerrate des demodulierten dequantisierten decodierten Signals konfiguriert ist, und
- eine Anpassungsvorrichtung nach Anspruch 4.

7. Vorrichtung eines Mobilfunknetzes, umfassend:
- eine Demodulationsvorrichtung, die so konfiguriert ist, dass sie das von der Antenne empfangene Funksignal demoduliert, ein demoduliertes Signal bereitstellt und jeden Wert des demodulierten Signals mithilfe einer Quantisierungstabelle quantisiert, wodurch ein quantisiertes demoduliertes Signal bereitgestellt wird,
- eine Kanal-Decodierungsvorrichtung in Form einer programmierbaren Schaltung, die so konfiguriert ist, dass sie ein Kanal-Decodierungsschema für das dequantisierte demodulierte Signal implementiert,
- mindestens einen Kommunikationsbus, der das quantisierte demodulierte Signal von der Demodulationsvorrichtung an die Kanal-Decodierungsvorrichtung übertragen kann, und
- eine Anpassungsvorrichtung nach Anspruch 4, die in der Demodulationsvorrichtung oder in der Kanal-Decodierungsvorrichtung enthalten ist.

8. Server, umfassend mindestens eine Vorrichtung nach einem der Ansprüche 5 bis 7.

9. Mobilfunknetzsystem, umfassend:
- mindestens eine Funkantenne, die zum Empfangen eines Funksignals konfiguriert ist,
- mindestens eine Einrichtung zur Implementierung von Basisfunktionen des Mobilfunknetzes, umfassend mindestens eine Demodulationsvorrichtung, die zum Demodulieren des von der Antenne empfangenen Funksignals, zum Bereitstellen eines demodulierten Signals, zum Quantisieren jedes Wertes des demodulierten Signals anhand einer Quantisierungstabelle, zum Bereitstellen eines quantisierten demodulierten Signals und zum Übertragen des quantisierten demodulierten Signals an ein Kanal-Decodierungsmodul konfiguriert ist,
- mindestens eine Einrichtung zur Implementierung von Funktionen auf hoher Ebene des Mobilfunknetzes, die mindestens eine Kanal-Decodierungsvorrichtung umfasst, die zum Empfangen des quantisierten demodulierten Signals von der Demodulationsvorrichtung, zum inversen Quantisieren jedes Wertes des quantisierten demodulierten Signals mit Hilfe einer Dequantisierungstabelle, wodurch ein dequantisiertes demoduliertes Signal bereitgestellt wird, zum Decodieren des dequantisierten demodulierten Signals und zum Berechnen einer Kanal-Decodierungsfehlerrate des demodulierten dequantisierten decodierten Signals konfiguriert ist,
- eine Anpassungsvorrichtung nach Anspruch 4, die in der Demodulationsvorrichtung oder in der Kanal-Decodierungsvorrichtung enthalten ist.

## Claims

1. Method for adapting a quantization table for data which are representative of a radio signal which is received by a radio antenna of a mobile network, comprising:
- obtaining information which is representative of a channel decoding error rate for a decoded quantized demodulated signal resulting from demodulating the radio signal received by said antenna, said demodulated radio signal having been quantized by said quantization table, and said quantized demodulated radio signal having undergone channel decoding,
- adapting the quantization table when the channel decoding error rate is above a determined threshold,
- transmitting information which is representative of the adaptation of the quantization table to a channel decoding device or to a demodulation device, adapting the quantization table comprising calculating a new quantization table on the basis of the demodulated received radio signal.

2. Method according to Claim 1, further comprising adapting the quantization table when the channel decoding error rate is below another determined threshold.

3. Method according to either one of Claims 1 and 2, wherein each value of the demodulated signal is representative of a logarithmic likelihood ratio of a symbol of said radio signal received by said antenna.

4. Device for adapting a quantization table for data which are representative of a radio signal which is received by a radio antenna of a mobile network, comprising a processor and a memory which are configured to:
- obtain information which is representative of a channel decoding error rate for a decoded quantized demodulated signal resulting from demodulating the radio signal received by said antenna, said demodulated radio signal having been quantized by said quantization table, and said quantized demodulated radio signal having undergone channel decoding, and
- adapt the quantization table when the channel decoding error rate is above a determined threshold,
- transmit information which is representative of the adaptation of the quantization table to a channel decoding device or to a demodulation device, the quantization table being adapted taking account of a new quantization table calculated on the basis of the demodulated radio signal.

5. Device for demodulating a radio signal received by a radio antenna of a mobile network, comprising:
- a demodulation module configured to demodulate said radio signal received by said antenna, providing a demodulated signal,
- a quantization module configured to quantize each value of said demodulated signal using a quantization table, providing a quantized demodulated signal,
- a transmission module configured to transmit said quantized demodulated signal to a channel decoding module, and
- an adaptation device according to Claim 4.

6. Device for channel decoding a quantized demodulated signal, comprising:
- a reception module configured to receive said quantized demodulated signal originating from a demodulation device configured to demodulate a radio signal received by a radio antenna of a mobile network,
- an inverse quantization module configured to inversely quantize each value of said quantized demodulated signal using a dequantization table, providing a dequantized demodulated signal,
- a channel decoding module configured to decode said dequantized demodulated signal,
- a calculation module configured to calculate a channel decoding error rate of said decoded dequantized demodulated signal, and
- an adaptation device according to Claim 4.

7. Device of a mobile network, comprising:
- a demodulation device configured to demodulate said radio signal received by said antenna, providing a demodulated signal, and to quantize each value of said demodulated signal using a quantization table, providing a quantized demodulated signal,
- a channel decoding device in the form of a programmable circuit configured to implement a channel decoding scheme for the dequantized demodulated signal,
- at least one communication bus which is able to transmit the quantized demodulated signal from the demodulation device to the channel decoding device, and
- an adaptation device according to Claim 4 comprised in the demodulation device or in the channel decoding device.

8. Server comprising at least one device according to any one of Claims 5 to 7.

9. Mobile network system, comprising:
- at least one radio antenna, configured to receive a radio signal,
- at least one equipment for implementing low functions of the mobile network, comprising at least one demodulation device configured to demodulate said radio signal received by said antenna, providing a demodulated signal, to quantize each value of said demodulated signal using a quantization table, providing a quantized demodulated signal, and to transmit said quantized demodulated signal to a channel decoding module,
- at least one equipment for implementing high functions of the mobile network, comprising at least one channel decoding device configured to receive said quantized demodulated signal originating from the demodulation device, to inversely quantize each value of said quantized demodulated signal using a dequantization table, providing a dequantized demodulated signal, to decode said dequantized demodulated signal, and to calculate a channel decoding error rate for said decoded dequantized demodulated signal,
- an adaptation device according to Claim 4 comprised in the demodulation device or in the channel decoding device.
